(19) Europäisches Patentamt
European Patent Office
Office européen des brevets

(11) EP 3 786 651 B1

(12) EUROPÄISCHE PATENTSCHRIFT

(45) Veröffentlichungstag und Bekanntmachung des Hinweises auf die Patenterteilung:
06.09.2023 Patentblatt 2023/36

(21) Anmeldenummer: 20184134.3

(22) Anmeldetag: 06.07.2020

(51) Internationale Patentklassifikation (IPC):
G01R 31/00 (2006.01)     G06F 30/367 (2020.01)

(52) Gemeinsame Patentklassifikation (CPC):
G01R 31/001; G06F 30/367

(54) **VERFAHREN UND VORRICHTUNG ZUM BEREITSTELLEN EINES VERHALTENSMODELLS FÜR DIE SIMULATION VON ELEKTROMAGNETISCHEN STÖREMISSIONEN EINER ELEKTRISCHEN BZW. ELEKTRONISCHEN KOMPONENTE**

METHOD AND DEVICE FOR PROVIDING A BEHAVIOUR MODEL FOR SIMULATING ELECTROMAGNETIC INTERFERENCE EMISSIONS OF AN ELECTRICAL OR ELECTRONIC COMPONENT

PROCÉDÉ ET DISPOSITIF DE FOURNITURE D'UN MODÈLE DE COMPORTEMENT POUR LA SIMULATION DES ÉMISSIONS D'INTERFÉRENCE ÉLECTROMAGNÉTIQUE D'UN COMPOSANT ÉLECTRIQUE OU ÉLECTRONIQUE

(84) Benannte Vertragsstaaten:
AL AT BE BG CH CY CZ DE DK EE ES FI FR GB GR HR HU IE IS IT LI LT LU LV MC MK MT NL NO PL PT RO RS SE SI SK SM TR

(30) Priorität: 27.08.2019 DE 102019212783

(43) Veröffentlichungstag der Anmeldung:
03.03.2021 Patentblatt 2021/09

(73) Patentinhaber: Robert Bosch GmbH
70442 Stuttgart (DE)

(72) Erfinder:
• Aichele, Hermann
72762 Reutlingen (DE)
• Hillenbrand, Philipp
72622 Nürtingen (DE)

(56) Entgegenhaltungen:
DE-A1-102009 002 550     US-A1- 2017 091 373

• HILLENBRAND P ET AL: "Frequency domain EMI-simulation and resonance analysis of a DCDC-converter", 2016 INTERNATIONAL SYMPOSIUM ON ELECTROMAGNETIC COMPATIBILITY - EMC EUROPE, IEEE, 5. September 2016 (2016-09-05), Seiten 176-181, XP032995753, DOI: 10.1109/EMCEUROPE.2016.7739186 [gefunden am 2016-11-08]
• LABUSSIERE-DORGAN C ET AL: "Modeling the Electromagnetic Emission of a Microcontroller Using a Single Model", IEEE TRANSACTIONS ON ELECTROMAGNETIC COMPATIBILITY, IEEE SERVICE CENTER , NEW YORK , NY, US, Bd. 50, Nr. 1, 1. Februar 2008 (2008-02-01), Seiten 22-34, XP011203544, ISSN: 0018-9375
• NEUMAYER R ET AL: "Continuous simulation of system-level automotive EMC problems", 2003 IEEE INTERNATIONAL SYMPOSIUM ON ELECTROMAGNETIC COMPATIBILITY. EMC. SYMPOSIUM RECORD. BOSTON, MA, AUG. 18 - 22, 2003; [INTERNATIONL SYMPOSIUM ON ELECTROMAGNETIC COMPATIBILITY], NEW YORK, NY : IEEE, US, Bd. 1, 18. August 2003 (2003-08-18), Seiten 409-413, XP010660841, DOI: 10.1109/ISEMC.2003.1236631 ISBN: 978-0-7803-7835-3

**Beschreibung**

Technisches Gebiet

Die Erfindung betrifft das Gebiet der Simulation der elektromagnetischen Verträglichkeit von elektrischen bzw. elektronischen Komponenten. Insbesondere betrifft die vorliegende Erfindung das Bereitstellen von EMV-Verhaltensmodellen (EMV: elektromagnetische Verträglichkeit) für die Simulation von elektromagnetischen Störemissionen von Komponenten, um ein Verhalten der Komponente in einem realen System vorherzusagen.

Technischer Hintergrund

In der Praxis wird das EMV-Verhalten von elektrischen bzw. elektronischen Komponenten in einem System simuliert, um festzustellen, ob zum einen ein störungsfreier Betrieb des Systems möglich ist, und ob zum anderen die Belastung der Umgebung des Systems durch elektromagnetische Strahlung die vorgegebenen Grenzwerte nicht überschreitet. Ein wesentliches Kennzeichen des EMV-Verhaltensmodells ist, dass lediglich das Verhalten der Komponente beschrieben wird, ohne relevante Informationen über den Aufbau der Komponente preiszugeben. Dadurch kann das Knowhow in der Komponente geschützt werden, und gleichzeitig wird für die Komponente ein Simulationsmodell zur Verfügung gestellt werden, das das Verhalten bezüglich elektromagnetischer Störemissionen der Komponente hinreichend beschreibt.

Dokument HILLENBRAND P. et al.: "Frequency domain E MI-simulation and resonance analysis of a DCDC-converter", 2016 INTERNATIONAL SYMPOSIUM ON ELECTROMAGNETIC COMPATIBILITY - EMC EUROPE, IEEE, 5. September 2016, Seiten 176-181 offenbart ein Verfahren zur EMV-Simulation eines DC DC Wandler, elektromagnetische Interferenzen vorherzusagen, wobei das Modell vorsieht, nichtlineare und zeitvariante Halbleiterschalter des Wandlers durch durch eine Messung erhaltene Spannungsquellen während des Betriebs des Wandlers zu ersetzen.

Dokument US 2017/091373 A1 offenbart ein Verfahren zum Unterdrücken einer elektromagnetischen Interferenz einer integrierten Schaltung, wobei ein zu bewertendes Schaltkreismodell erstellt wird und dieses abhängig von einer berechneten elektromagnetischen Interferenz korrigiert wird.

Dokument DE 10 2009 002550 A1 offenbart ein Verfahren zur Erstellung eines zur Analyse der elektromagnetischen Verträglichkeit geeigneten Ersatzschaltbildes.

Offenbarung der Erfindung

Erfindungsgemäß sind ein Verfahren zum Bereitstellen eines EMV-Verhaltensmodells für die Simulation einer elektromagnetischen Störemission einer elektrischen bzw. elektronischen Komponente gemäß Anspruch 1 sowie eine entsprechende Vorrichtung, ein Verfahren zum Simulieren eines EMV-Verhaltens einer elektrischen bzw. elektronischen Komponente und eine Simulationsvorrichtung gemäß den nebengeordneten Ansprüchen vorgesehen.

Weitere Ausgestaltungen sind in den abhängigen Ansprüchen angegeben.

Gemäß einem ersten Aspekt ist ein computer-implementiertes Verfahren gemäß Anspruch 1 vorgesehen.

Die vollständige Simulation von elektromagnetischen Wechselwirkungen einer Komponente, wie z.B. eines Elektromotors, einer Zündkerze, einer Radioempfangseinheit und dergleichen, in einem System erfordert in der Regel ein ausführliches Wissen über die funktionalen und parasitären Elemente der Komponente. Simulationsmodelle müssten daher alle elektromagnetischen Kopplungseffekte innerhalb der Komponente und zwischen der Komponente und dem übrigen System berücksichtigen. Dazu ist jedoch ein aufwendiger Entwicklungsprozess notwendig, insbesondere wenn der interne Aufbau der Komponente ganz oder teilweise unbekannt ist.

Mithilfe von EMV-Verhaltensmodellen kann der Entwicklungsprozess und der Prozess der Evaluierung des Einsatzes der Komponente innerhalb eines Systems erheblich vereinfacht werden, insbesondere wenn die Komponente ein lineares und zeitinvariantes Verhalten aufweist. Derartige Verhaltensmodelle verwenden einen Anschluss-Äquivalenzschaltkreis, der das Verhalten der Komponente an den Anschlüssen wiedergibt, anstatt alle Interferenzquellen und Kopplungseffekte innerhalb der Komponente zu modellieren. Konventionelle Ansätze verwenden beispielsweise einen Äquivalenzschaltkreis basierend auf Norton oder Thevenin. Beispielsweise verwendet die Thevenin-Theorie Impedanzelemente in Kombination mit Stromquellen, um das Verhalten eines Anschlusses der Komponente zu modellieren.

Eine Möglichkeit ein EMV-Verhaltensmodell zu beschreiben, stellt das Touchstone-Format dar. Das Touchstone-Format ist herkömmlich als ein Textdatei-Format zum Speichern von Netzwerkparametern, meistens von Messdaten bekannt. In dem Touchstone-Format können Scattering-. Parameter, Admittanzparameter, Impedanzparameter, Hybrid-h-Parameter sowie Hybrid-g-Parameter beschrieben werden. Das Touchstone-Format kann auch dazu verwendet werden, das Verhalten einer elektrischen bzw. elektronischen Komponente hinsichtlich ihres EMV-Verhaltens für alle elektrischen Anschlüsse der Komponente basierend auf Admittanzen und damit gekoppelten Stromquellen zu beschreiben.

Das Touchstone-Format kann zwar verwendet werden, das Verhalten einer elektrischen bzw. elektronischen Komponente hinsichtlich ihres EMV-Verhaltens für alle elektrischen Anschlüsse der Komponente basierend auf Admittanzen/Impedanzen und damit gekoppelten Quellenelemente zu beschreiben. Eine Vielzahl von Komponenten weisen jedoch unabhängige Quellenelemente auf, die ebenfalls in einem EMV-Verhaltensmodell berücksichtigt werden müssen. Das Touchstone-Format ist aktuell für die Beschreibung von derartigen Verhaltensmodellen ungeeignet, weil unabhängige Quellenelemente, wie beispielsweise unabhängige Strom oder Spannungsquellen, innerhalb der Komponente nicht in dieses Format integriert werden können.

Diesbezüglich ist daher vorgesehen, das EMV-Verhaltensmodell in einem Format vorzusehen, das es ermöglicht, unabhängige Quellenelemente, wie beispielsweise Strom oder Spannungsquellen, in das EMV-Verhaltensmodell einzubeziehen, ohne dass eine entsprechende Simulationssoftware, die das EMV-Verhaltensmodell auswertet, modifiziert werden muss. Diesbezüglich wird das Verhaltensmodell in einer Form bereitgestellt, die es ermöglicht, unabhängige Quellen des Modells einzubeziehen. Dazu wird das Verhaltensmodell mit einem zusätzlichen logischen Anschluss versehen, der als ein externer Steueranschluss reserviert wird. In einer darauf basierenden EMV-Simulation kann dieser Steueranschluss mit einer idealen Spannungsquelle angeregt werden, so dass die entsprechenden dadurch gesteuerten Quellenelemente aktiviert bzw. deaktiviert werden können.

Der Steueranschluss ist unabhängig von den übrigen Anschlüssen des Verhaltensmodells, wobei die Impedanz zwischen dem Steueranschluss und einem Massepotenzial als Freiheitsgrad nutzbar ist. Diese Impedanz ist von außen messbar und kann als Indikator für die Modellqualität verwendet werden. Beispielsweise kann der Wert der Impedanz zwischen dem Steueranschluss und dem Massepotenzial eine Funktion der linearen Abhängigkeit und des Signal-Rausch-Verhältnisses der für die Prüfungscharakterisierung verwendeten Signale sein. Insgesamt kann vorgesehen sein, dass der Wert der Impedanz die Modellqualität bzw. die Vorhersagewahrscheinlichkeit angibt. Dadurch ist es möglich, während einer EMV-Simulation den Wert der Impedanz an dem Steueranschluss für die Simulation zu nutzen.

Ein grundlegender Vorteil der Verwendung des Touchstone-Modells besteht darin, dass dieses nur Daten bezüglich des Verhaltens an den Anschlüssen der Komponente enthält, so dass ein Austausch des EMV-Verhaltensmodells zwischen unterschiedlichen Parteien ohne die Preisgabe von System-Knowhow möglich ist. Die Nutzung des Anschluss-Äquivalenzschaltkreises als Dateiformat für das EMV-Verhaltensmodell ermöglicht die Definition von passiven Netzwerkparametern, wie Scattering, Admittanz, Impedanz und Hybridparametern. Um die unabhängigen Quellen des EMV-Verhaltensmodells zu berücksichtigen, kann mithilfe eines Steueranschlusses die Stromquelle an den übrigen Anschluss gesteuert werden.

Weiterhin kann das Verhaltensmodell die Anschlüsse in Bezug auf ein Massepotenzial und in Bezug zu den übrigen der Anschlüsse definieren.

Es kann vorgesehen sein, dass das Verhaltensmodell die elektrische Größe des passiven elektrischen Bauelements des Steueranschlusses so vorgibt, dass diese eine Modellqualität oder eine Vorhersagewahrscheinlichkeit angibt.

Weiterhin kann zur Simulation des Verhaltens der Komponente ausschließlich das Verhaltensmodell verwendet werden.

Insbesondere kann das Verhaltensmodell in einem Touchstone-Format bereitgestellt werden.

Zudem kann das Verhaltensmodell eine reale Komponente mit einer Anzahl von elektrischen Anschlüssen beschreiben und dieselbe Anzahl von Anschlüssen zuzüglich eines Steueranschlusses für die Simulation bereitstellen.

Gemäß einem weiteren Aspekt ist eine Vorrichtung gemäß Anspruch 7 vorgesehen.

Eine solche Vorrichtung ermöglicht die automatische oder halbautomatische Vermessung der Komponente insbesondere durch eine Computerimplementierung des oben beschriebenen Verfahrens zum Bereitstellen des Verhaltensmodells.

Gemäß einem weiteren Aspekt ist ein Verfahren zur Simulation einer Komponente gemäß Anspruch 8 vorgesehen.

Gemäß einem weiteren Aspekt ist eine Simulationsvorrichtung zur Simulation einer Komponente gemäß Anspruch 9 vorgesehen.

Eine solche Simulationsvorrichtung ermöglicht anwenderseitig die computerimplementierte EMV-Simulation der Komponente durch Nutzung des bereitgestellten Verhaltensmodells.

Kurzbeschreibung der Zeichnungen

Ausführungsformen werden nachfolgend anhand der beigefügten Zeichnungen näher erläutert. Es zeigen:

Figur 1 eine graphische Darstellung der Modellbeschreibung eines Anschluss-Äquivalenzschaltkreises;

Figur 2 eine Anordnung zur Messung der Stromquellen für den Anschluss-Äquivalenzschaltkreis;

Figur 3 eine bildliche Darstellung eines Verhaltensmodells mit einem Steueranschluss für unabhängige Strom- und/oder Spannungsquellen; und

Figur 4 ein Flussdiagramm zur Veranschaulichung eines Verfahrens zum Bereitstellen eines EMV-Verhaltensmodells und Simulation einer elektrischen bzw. elektronischen Komponente basierend auf dem EMV-Verhaltensmodell.

Beschreibung von Ausführungsformen

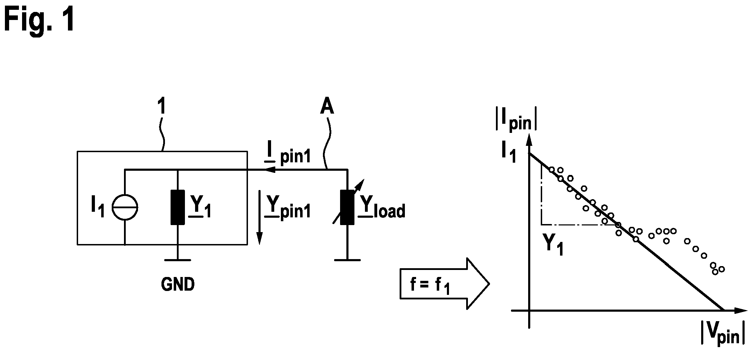

In Figur 1 ist eine beispielhafte Modellkomponente 1 mit nur einem Anschluss A dargestellt, um die allgemeine Idee des Anschluss-Äquivalenzschaltkreises und das entsprechende EMV-Verhaltensmodell zu illustrieren. Die Modellkomponente 1 entspricht einem Simulationsmodell für eine elektrische bzw. elektronische Komponente. Die elektrische bzw. elektronische Komponente kann auch mehrere Anschlüsse aufweisen.

Jeder Anschluss A (und alle weiteren Anschlüsse) ist bezüglich eines Massepotenzials GND definiert, wobei $V_{pin1}$ die Spannung an dem Anschluss und $I_{pin1}$ der Strom, der in den Anschluss A hineinfließt, entsprechen. Die Komponente 1 kann aktiv oder passiv sein, wobei im Folgenden angenommen wird, dass der Anschluss ein aktiver Anschluss ist. Die Verhaltenscharakterisierung des Anschlusses A erfolgt durch eine Bestimmung einer frequenzabhängigen Impedanz/Admittanz und einer frequenzabhängigen Strom- bzw. Spannungsquelle.

Die Verhaltenscharakterisierung des Anschlusses A kann durch Anschließen von verschiedenen externen Lasten $\underline{Y}_{load}$ an den Anschluss A durchgeführt werden. Jede der Lastbedingungen erzeugt ein Wertepaar der Spannung $V_{pin1}$ und des Stroms $I_{pin1}$. In der Zeitdomäne existiert ein Wertepaar für jeden Zeitschritt. In der Frequenzdomäne existiert ein komplexes Wertepaar $\underline{V}_{pin1}$, $\underline{I}_{pin1}$ für alle Frequenzen.

Figur 1 stellt für den Schaltkreis, dessen Anschluss A mit einer Impedanz $\underline{Y}_1$ und einer Stromquelle $\underline{I}_1$ versehen ist, einen Verlauf zwischen dem Magnitudenbetrag von $|V_{pin}|$ und $|I_{pin}|$ für eine bestimmte Frequenz $f = f1$ dar. Jeder der Punkte in dem Diagramm stellt einen Lastzustand $\underline{Y}_{load}$ dar. Daher erfordern Simulationen in der Frequenzdomäne eine lineare Funktion zwischen beiden Werten, die durch die dargestellte Linie durch die Lastzustände definiert ist. Die Steigung dieser Linie entspricht der Magnitude der Impedanz $|\underline{Y}_1| = \Delta |V_{pin}| / \Delta |I_{pin}|$ und der Schnittpunkt der Linie mit der $|I_{pin}|$-Achse definiert die Magnitude der Quelle $|\underline{I}_1| = |I_{pin1}|$ (0).

Die Erstellung des gesamten Verhaltensmodells erfordert diese Vorgehensweise mit komplexen Werten für alle interessierenden Frequenzpunkte. Da auch die Phasenlagen der Ströme und Spannungen relevant sind, müssen die Phasenbezüge zwischen den Quellenelementen als auch bezüglich der für die Vermessung verwendeten Lastbedingungen zueinander bekannt sein. In der Praxis ist dieser Phasenbezug selten bekannt. Um ein numerisch stabiles Ergebnis zu erhalten, sollten die beiden Lastpunkte möglichst weit voneinander entfernt sein. Dies erfordert jedoch eine starke Änderung der Lastbedingung, die oft zu unerwünschten nichtlinearen Verhaltensänderungen der vermessenen Komponente führen kann. Bei einer höheren Anzahl von Anschlüssen steigt die Anzahl der notwendigen Lastzustände an. Ein Modell mit N Anschlüssen erfordert N+1-Lastzustände.

Es ist numerisch vorteilhaft, wenn die Lastzustände hohe Werte von $\Delta \underline{V}_{pin}$ und $\Delta \underline{I}_{pin}$ aufweisen, jedoch kann ein lineares Verhalten der Komponente nur bei benachbarten Lastbedingungen gewährleistet werden. Zusätzlich erfordern die komplexen Werte von $\Delta \underline{V}_{pin}$ und $\Delta \underline{I}_{pin}$ relative Phaseninformationen zwischen den Lastbedingungen, d. h. sie erfordern eine exakte Zeitdifferenz zwischen den Messungen.

In der Regel weisen Komponenten an ihren Anschlüssen eine Mischung aus linear zeitinvariantem und nichtlinear oder zeitvarianten Verhalten auf. Für die nachfolgend beschriebene Modellerstellung wird angenommen, dass die äquivalenten Admittanzen des Anschluss-Äquivalenzschaltkreises ein lediglich linear zeitinvariantes Verhalten aufweisen und mit entsprechenden Elementen beschrieben werden können. Dies ist möglich, da die passiven linearen zeitinvarianten Strukturen, wie z.B. passive EMI-Filter nahe der Anschlüsse der Komponente, in der Regel die wichtigste Einflussgröße auf die äquivalente Impedanz/Admittanz darstellen.

Zur Vermessung der passiven Bauelemente kann eine Messung mit einem Vektornetzwerkanalysator (VNA) durchgeführt werden, die die elektrische Größe der Admittanzelemente/Impedanzelemente in einem passiven Zustand der Komponente bestimmt. Die VNA-Messung liefert Scattering-Parameter, die zu Admittanzparametern transformierbar sind und die den Admittanzelemente/Impedanzelementen des Thévenin-Äquivalenzschaltkreises entsprechen können. Nach diesem Schritt sind die Stromquellen (Quellenelemente) des Äquivalenzschaltkreises die verbleibenden unbekannten Elemente.

Durch Messung an einem einzelnen Lastzustand kann die Größe der entsprechenden Stromquelle ermittelt werden. Da das gemessenen Admittanzelement/Impedanzelement die Steigung der Linie definiert, ist lediglich ein Wertepaar von $V_{pin1}$ und $I_{pin1}$, notwendig, um das Modell zu konstruieren. Insbesondere entspricht bei einer gemessenen Admittanz $\underline{Y}_{load}$ ist lediglich $V_{pin1}$ oder $I_{pin1}$, notwendig, um das Modell zu erzeugen, mit $\underline{Y}_{load} = I_{pin1}$, durch $V_{pin1}$. Dadurch kann eine stabile Modellerzeugung gewährleistet werden, weil nur ein Lastzustand notwendig ist, unabhängig von der Anzahl der Anschlüsse.

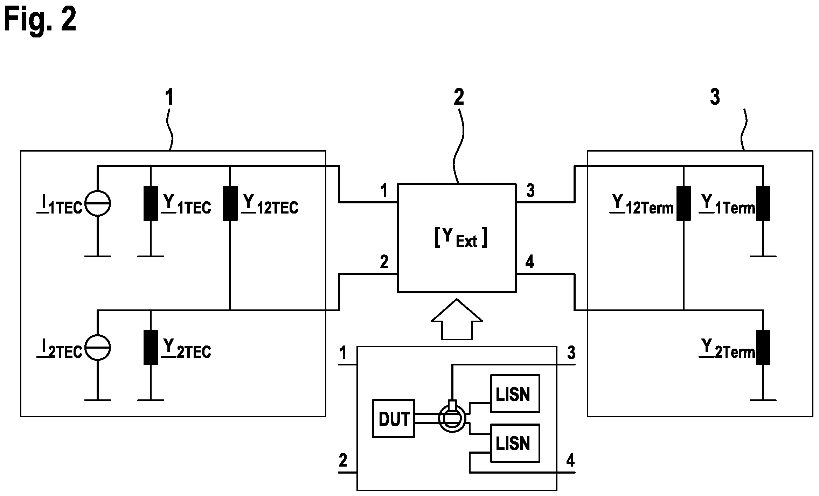

Zur Messung der Stromquellen für den Anschluss-Äquivalenzschaltkreis ist eine Anordnung, wie in Figur 2 dargestellt, vorgesehen. Die Messung sieht einen Anschluss der Komponente 1 über ein Messmodell 2 an eine Messeinrichtung 3, wie z.B. ein Oszilloskop, vor. Wie oben beschrieben, sind alle Admittanzen/Impedanzen in einem passiven Zustand messbar. Die Berechnung der Quellen der Komponenten verwendet die Notation $[Y_{tec}]$ , die die die Admittanzmatrix der Komponente, d. h. des Anschluss-Äquivalenzschaltkreises, definiert. $[Y_{ext}]$ entspricht den Admittanzen der Messeinrichtung 3 messbar mit einem VNA und $[Y_{term}]$ entspricht der Admittanzmatrix der Leitungsabschlüsse, die in der Messeinrichtung 3, wie beispielsweise dem Oszilloskop, verwendet wird.

Das vollständige System wird wie folgt zu einer Impedanzmatrix zusammengefasst und eine Knotenanalyse des Systems ausgeführt. Hier sind die Stromquellen nur innerhalb der Modellkomponente 1 vorgesehen.

$$\left( \, [\underline{Y}_{TEC}] + [\underline{Y}_{Ext}] + [\underline{Y}_{Term}] \right) \cdot \begin{pmatrix} \varphi_{TEC} \\ \vdots \\ \varphi_{Term} \end{pmatrix} = \begin{pmatrix} I_{TEC} \\ \vdots \\ 0 \end{pmatrix} \qquad (1)$$

With

$$[\underline{Y}_{TEC}] = \begin{bmatrix} \underline{Y}_{TEC} & \cdots & 0 \\ \vdots & \ddots & \vdots \\ 0 & \cdots & 0 \end{bmatrix}, [\underline{Y}_{Term}] = \begin{bmatrix} 0 & \cdots & 0 \\ \vdots & \ddots & \vdots \\ 0 & \cdots & \underline{Y}_{Term} \end{bmatrix}$$

Anschließend werden die Stromquellen wie folgt ermittelt:

$$[Y] = \left( \, [\underline{Y}_{TEC}] + [\underline{Y}_{Ext}] + [\underline{Y}_{Term}] \right) = \begin{bmatrix} A & B \\ C & D \end{bmatrix}$$

$$\begin{bmatrix} A & -1 \\ C & 0 \end{bmatrix} \cdot \begin{pmatrix} \varphi_{TEC} \\ \vdots \\ I_{TEC} \end{pmatrix} = \begin{bmatrix} -B & 0 \\ -D & 1 \end{bmatrix} \begin{pmatrix} \varphi_{Term} \\ \vdots \\ 0 \end{pmatrix}$$

$$\begin{pmatrix} \varphi_{TEC} \\ \vdots \\ I_{TEC} \end{pmatrix} = \begin{bmatrix} A & -1 \\ C & 0 \end{bmatrix} / \begin{bmatrix} -B & 0 \\ -D & 1 \end{bmatrix} \cdot \begin{pmatrix} \varphi_{Term} \\ \vdots \\ 0 \end{pmatrix}$$

wobei $\varphi_{TEC}$ der äquivalenten Spannung des betreffenden Quellenelements bzw. $I_{tec}$ des äquivalenten Stroms des betreffenden Quellenelements des Anschluss-Äquivalenzschaltkreises entspricht. Eine erfolgreiche Berechnung der äquivalenten Stromquellen $I_{tec}$ erfordern linear unabhängige Potenziale $\varphi_{term.}$, die mithilfe eines Oszilloskops gemessen und/oder bestimmt werden können. Auf diese Weise können die Admittanzen und die zugehörigen Stromquellen für jeden Anschluss bestimmt werden.

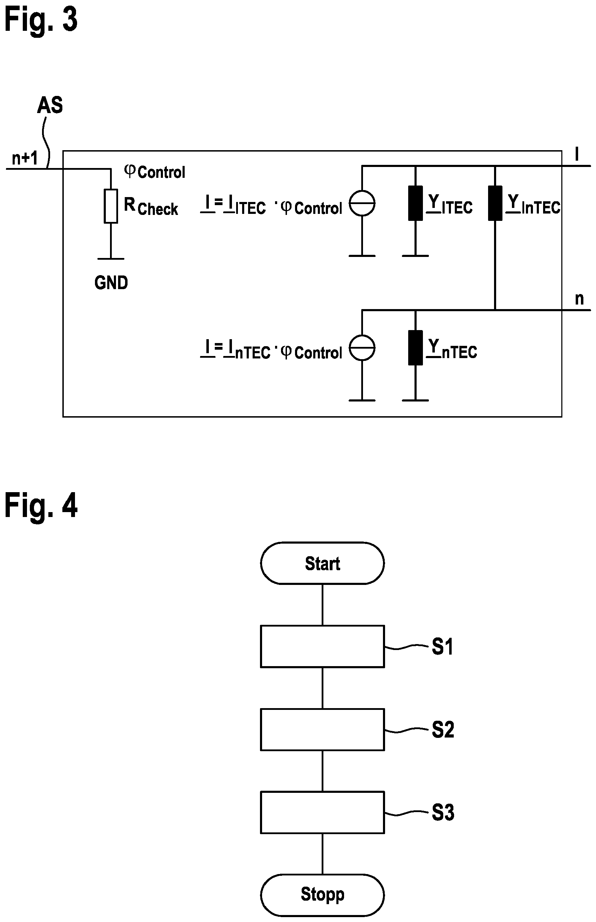

Um die unabhängigen Stromquellen in dem Anschluss-Äquivalenzmodell zu berücksichtigen, kann dieses, wie in der Repräsentation der Figur 3 schematisch dargestellt, einen weiteren Steueranschluss AS umfassen, der zum Schalten der Anschlüsse bzw. der Strom- und/oder Spannungsquellen der Anschlüsse A von einem passiven in einen aktiven Zustand vorgesehen ist. Somit kann ein Schaltzustand der Komponenten durch Anlegen einer Steuerspannung im Verlauf der Simulation mit dem EMV-Verhaltensmodell simuliert werden.

Daher ist vorgesehen, das EMV-Verhaltensmodell in einem Format vorzusehen, das es ermöglicht, unabhängige Quellenelemente, wie beispielsweise Strom oder Spannungsquellen, in das EMV-Verhaltensmodell einzubeziehen, ohne dass eine entsprechende Simulationssoftware, die das EMV-Verhaltensmodell auswertet, modifizieren zu müssen. Diesbezüglich wird das Verhaltensmodell in einer Form bereitgestellt, die es ermöglicht, unabhängige Quellen des Modells einzubeziehen.

In einer darauf basierenden EMV-Simulation kann der in dem Verhaltensmodell vorgesehene Steueranschluss AS mit einer idealen Spannungsquelle angeregt werden, so dass die entsprechenden dadurch gesteuerten Quellenelemente aktiviert bzw. deaktiviert werden können.

Der Steueranschluss AS ist unabhängig von den übrigen Anschlüssen A des Verhaltensmodells, wobei die Impedanz $R_{check}$ zwischen dem Steueranschluss AS und einem Massepotenzial GND als Freiheitsgrad nutzbar ist. Diese Impedanz ist von außen messbar und kann als Indikator für die Modellqualität verwendet werden. Beispielsweise kann der Wert der Impedanz zwischen dem Steueranschluss AS und dem Massepotenzial GND eine Funktion der linearen Abhängigkeit und des Signal-Rausch-Verhältnisses der für die Prüfungscharakterisierung verwendeten Signale sein. Insgesamt kann vorgesehen sein, dass der Wert der Impedanz die Modellqualität bzw. die Vorhersagewahrscheinlichkeit angibt. Dadurch ist es möglich, während einer EMV-Simulation den Wert der Impedanz $R_{check}$ an dem Steueranschluss AS für die Simulation zu nutzen.

Ein so erstelltes Verhaltensmodell kann in einem Beschreibungsformat dargestellt werden, wie es beispielsweise als ein Touchstone-Format bekannt ist. Das Touchstone-Format sieht die Definition der Abhängigkeit einer Stromquelle von einer Anschlussspannung des Steueranschlusses vor, so dass die Anschlüsse des Simulationsmodells der Komponente während der Simulation in einen passiven oder aktiven Zustand geschaltet werden können.

Figur 4 zeigt anhand eines Flussdiagramms eine beispielhafte Anwendung des vorgeschlagenen Verhaltensmodells.

In Schritt S1 wird von einem Hersteller eine EMV-Verhaltensmodell bereitgestellt, das zur Simulation von unabhängigen Strom- und/oder Spannungsquellen einen zusätzlichen Steueranschluss aufweist.

Nach der Übermittlung des Verhaltensmodells kann dieses zur Simulation des EMV-Verhaltens der durch die Modellkomponente des Verhaltensmodells beschriebenen Komponente genutzt werden.

In Schritt S2 wird durch eine Simulationssoftware der Steueranschluss mit einer vorgegebenen Spannung von z.B. 1V belegt, um die unabhängigen Strom- und/oder Spannungsquelle zu aktivieren.

In Schritt S3 wird die Simulation durchgeführt und das Frequenzverhalten der durch das Verhaltensmodell definierten Komponente ermittelt.

## Patentansprüche

1. Computer-implementiertes Verfahren zum Bereitstellen eines EMV-Verhaltensmodells in Form von Modelldaten für eine Simulation einer durch das EMV-Verhaltensmodell beschriebenen elektrischen oder elektronischen Komponente (1) in einer Simulationsvorrichtung, wobei das EMV-Verhaltensmodell das Verhalten an einem oder mehreren elektrischen Anschlüssen (A) der Komponente (1) beschreibt, indem das elektrische Verhalten an jedem der Anschlüsse (A) der Komponente durch einen Anschluss-Äquivalenzschaltkreis als die Wirkung von komplexen, frequenzabhängigen elektrischen Größen von passiven elektrischen Bauelementen, insbesondere Admittanzen oder Impedanzen, und eines Quellenelements, welches eine Spannungs- und/oder einer Stromquelle umfasst, beschrieben wird, wobei das EMV-Verhaltensmodell einen zusätzlichen virtuellen Steueranschluss (AS) vorsieht, durch den in der Simulation die oder mehrere der Spannungs- und/oder Stromquellen steuerbar ist, wobei die frequenzabhängigen Quellenelemente jedes Anschlusses (A) mithilfe eines Oszilloskops und anschließender Fourier-Transformation bestimmt werden.

2. Verfahren nach Anspruch 1, wobei das EMV-Verhaltensmodell die Anschlüsse (A) in Bezug auf ein Massepotenzial und in Bezug zu den übrigen der Anschlüsse definiert.

3. Verfahren nach Anspruch 1 oder 2, wobei das EMV-Verhaltensmodell die elektrische Größe des passiven elektrischen Bauelements des Steueranschlusses (AS) so vorgibt, dass diese eine Modellqualität, insbesondere eine Vorhersagewahrscheinlichkeit, angibt.

4. Verfahren nach einem der Ansprüche 1 bis 3, wobei ein Verhalten der Komponente (1) simuliert wird, wobei zur Simulation des Verhaltens der Komponente (1) ausschließlich das EMV-Verhaltensmodell und eine Vorgabe einer externen Strom- oder Spannungsquelle zur Anregung des EMV-Verhaltensmodells verwendet wird.

5. Verfahren nach einem der Ansprüche 1 bis 4, wobei das EMV-Verhaltensmodell in einem Touchstone-Format bereitgestellt wird.

6. Verfahren nach einem der Ansprüche 1 bis 5, wobei das EMV-Verhaltensmodell eine reale Komponente mit einer Anzahl von elektrischen Anschlüssen (A) beschreibt und dieselbe Anzahl von Anschlüssen zuzüglich des virtuellen Steueranschlusses (AS) für die Simulation bereitstellt.

7. Vorrichtung ausgebildet zum Bereitstellen eines EMV-Verhaltensmodells, in Form von Modelldaten für eine Simulation einer durch das EMV-Verhaltensmodell beschriebenen elektrischen oder elektronischen Komponente (1) in einer Simulationsvorrichtung, wobei das EMV-Verhaltensmodell das Verhalten an einem oder mehreren elektrischen Anschlüssen (A) der Komponente (1) beschreibt, indem das elektrische Verhalten an jedem der Anschlüsse (A) der Komponente durch einen Anschluss-Äquivalenzschaltkreis als die Wirkung von komplexen, frequenzabhängigen elektrischen Größen von passiven elektrischen Bauelementen, insbesondere Admittanzen oder Impedanzen, und eines Quellenelements, welche eine Spannungs- und/oder einer Stromquelle umfasst, beschrieben wird, wobei die Vorrichtung ausgebildet ist, um das EMV-Verhaltensmodell mit einem zusätzlichen virtuellen Steueranschluss (AS) bereitzustellen, durch den in der Simulation die oder mehrere der Spannungs- und/oder Stromquellen steuerbar ist, wobei die frequenzabhängigen Quellenelemente jedes Anschlusses (A) mithilfe eines Oszilloskops und anschließender Fourier-Transformation bestimmt sind.

8. Verfahren zur Simulation einer Komponente (1) anhand eines der Komponente (1) zugeordneten EMV-Verhaltensmodells, das entsprechend eines Verfahrens nach einem der Ansprüche 1 bis 6 ermittelt ist, wobei der virtuelle Steueranschluss des EMV-Verhaltensmodells mit einer vorgegebenen Steuergröße belegt wird, bevor das Verhalten der Komponente (1) simuliert wird.

9. Simulationsvorrichtung zur Simulation einer Komponente (1) anhand eines der Komponente (1) zugeordneten EMV-Verhaltensmodells, wobei die Simulationsvorrichtung ausgebildet ist, um eine Simulation basierend von dem entsprechend eines Verfahrens nach einem der Ansprüche 1 bis 6 ermittelten EMV-Verhaltensmodells durchzuführen, wobei die Simulationsvorrichtung ausgebildet ist, um den virtuellen Steueranschluss des EMV-Verhaltensmodells mit einer vorgegebenen Steuergröße zu belegen, bevor das Verhalten der Komponente (1) simuliert wird.

10. Computerprogramm, umfassend Befehle, die bei der Ausführung des Programms durch einen Computer diesen veranlassen, alle Schritte eines Verfahrens nach einem der Ansprüche 1 bis 6 auszuführen.

11. Maschinenlesbares Speichermedium, auf welchem ein Computerprogramm nach Anspruch 10 gespeichert ist.

**Claims**

1. Computer-implemented method for providing an EMC behaviour model in the form of model data for simulating an electrical or electronic component (1) that is described by the EMC behaviour model in a simulation apparatus, wherein the EMC behaviour model describes the behaviour at one or more electrical connections (A) of the component (1) by virtue of the electrical behaviour at each of the connections (A) of the component being described by a connection equivalent circuit as the effect of complex, frequency-dependent electrical variables of passive electrical components, in particular admittances or impedances, and of a source element comprising a voltage and/or current source, wherein the EMC behaviour model provides an additional, virtual control connection (AS) which can be used to control the voltage and/or current source or a plurality of the voltage and/or current sources in the simulation, wherein the frequency-dependent source elements of each connection (A) are determined with the aid of an oscilloscope and a subsequent Fourier transform.

2. Method according to Claim 1, wherein the EMC behaviour model defines the connections (A) with respect to an earth potential and with respect to the other connections.

3. Method according to Claim 1 or 2, wherein the EMC behaviour model specifies the electrical variable of the passive electrical component of the control connection (AS) in such a manner that it indicates a model quality, in particular a prediction probability.

4. Method according to one of Claims 1 to 3, wherein a behaviour of the component (1) is simulated, wherein only the EMC behaviour model and a specification of an external current or voltage source for exciting the EMC behaviour model are used to simulate the behaviour of the component (1).

5. Method according to one of Claims 1 to 4, wherein the EMC behaviour model is provided in a touchstone format.

6. Method according to one of Claims 1 to 5, wherein the EMC behaviour model describes a real component having a number of electrical connections (A) and provides the same number of connections plus the virtual control connection (AS) for the simulation.

7. Apparatus designed to provide an EMC behaviour model in the form of model data for simulating an electrical or electronic component (1) that is described by the EMC behaviour model in a simulation apparatus, wherein the EMC behaviour model describes the behaviour at one or more electrical connections (A) of the component (1) by virtue of the electrical behaviour at each of the connections (A) of the component being described by a connection equivalent circuit as the effect of complex, frequency-dependent electrical variables of passive electrical components, in particular admittances or impedances, and of a source element comprising a voltage and/or current source, wherein the apparatus is designed to provide the EMC behaviour model with an additional, virtual control connection (AS) which can be used to control the voltage and/or current source or a plurality of the voltage and/or current sources in the simulation, wherein the frequency-dependent source elements of each connection (A) are determined with the aid of an oscilloscope and a subsequent Fourier transform.

8. Method for simulating a component (1) on the basis of an EMC behaviour model which is assigned to the component (1) and is determined in accordance with a method according to one of Claims 1 to 6, wherein a predefined control variable is assigned to the virtual control connection of the EMC behaviour model before the behaviour of the component (1) is simulated.

9. Simulation apparatus for simulating a component (1) on the basis of an EMC behaviour model assigned to the component (1), wherein the simulation apparatus is designed to carry out a simulation on the basis of the EMC behaviour model determined in accordance with a method according to one of Claims 1 to 6, wherein the simulation apparatus is designed to assign a predefined control variable to the virtual control connection of the EMC behaviour model before the behaviour of the component (1) is simulated.

10. Computer program comprising instructions which, when the program is executed by a computer, cause the latter to carry out all steps of a method according to one of Claims 1 to 6.

11. Machine-readable storage medium on which a computer program according to Claim 10 is stored.


**Revendications**

1. Procédé mis en œuvre par ordinateur pour la fourniture d'un modèle de comportement CEM sous forme de données modèle destinées à une simulation d'un composant (1) électrique ou électronique décrit par le modèle de comportement CEM dans un dispositif de simulation, dans lequel le modèle de comportement CEM décrit le comportement au niveau d'une ou de plusieurs bornes électriques (A) du composant (1) en décrivant le comportement électrique à chacune des bornes (A) du composant par un circuit équivalent de borne comme l'effet de grandeurs électriques complexes, dépendant de la fréquence, de composants électriques passifs, en particulier d'admittances ou d'impédances, et d'un élément source qui comprend une source de tension et/ou de courant, dans lequel le modèle de comportement CEM prévoit une borne de commande virtuelle (AS) supplémentaire qui permet de commander ladite ou les plusieurs sources de tension et/ou de courant dans la simulation, dans lequel les éléments source, dépendant de la fréquence, de chaque borne (A) sont déterminés à l'aide d'un oscilloscope et d'une transformation de Fourier consécutive.

2. Procédé selon la revendication 1, dans lequel le modèle de comportement CEM définit les bornes (A) par rapport à un potentiel de masse et par rapport aux autres bornes.

3. Procédé selon la revendication 1 ou 2, dans lequel le modèle de comportement CEM spécifie la grandeur électrique du composant électrique passif de la borne de commande (AS) de telle sorte que celle-ci indique une qualité de modèle, en particulier une probabilité de prédiction.

4. Procédé selon l'une quelconque des revendications 1 à 3, dans lequel un comportement du composant (1) est simulé, dans lequel pour la simulation du comportement du composant (1), seul le modèle de comportement CEM et une spécification d'une source de courant ou de tension externe sont utilisés pour stimuler le modèle de comportement CEM.

5. Procédé selon l'une quelconque des revendications 1 à 4, dans lequel le modèle de comportement CEM est fourni dans un format Touchstone.

6. Procédé selon l'une quelconque des revendications 1 à 5, dans lequel le modèle de comportement CEM décrit un composant réel pourvu d'un certain nombre de bornes électriques (A) et fournit le même nombre de bornes plus la borne de commande virtuelle (AS) pour la simulation.

7. Dispositif réalisé pour la fourniture d'un modèle de comportement CEM sous forme de données modèle destinées à une simulation d'un composant (1) électrique ou électronique décrit par le modèle de comportement CEM dans un dispositif de simulation, dans lequel le modèle de comportement CEM décrit le comportement au niveau d'une ou de plusieurs bornes électriques (A) du composant (1) en décrivant le comportement électrique à chacune des bornes (A) du composant par un circuit équivalent de borne comme l'effet de grandeurs électriques complexes, dépendant de la fréquence, de composants électriques passifs, en particulier d'admittances ou d'impédances, et d'un élément source qui comprend une source de tension et/ou de courant, dans lequel le dispositif est réalisé pour fournir le modèle de comportement CEM avec une borne de commande virtuelle (AS) supplémentaire qui permet de commander ladite ou les plusieurs sources de tension et/ou de courant dans la simulation, dans lequel les éléments source, dépendant de la fréquence, de chaque borne (A) sont déterminés à l'aide d'un oscilloscope et d'une transformation de Fourier consécutive.

8. Procédé de simulation d'un composant (1) à l'aide d'un modèle de comportement CEM associé au composant (1) et qui est déterminé selon un procédé selon l'une quelconque des revendications 1 à 6, dans lequel une grandeur de commande spécifiée est appliquée à la borne de commande virtuelle du modèle de comportement CEM avant la simulation du comportement du composant (1).

9. Dispositif de simulation pour la simulation d'un composant (1) à l'aide d'un modèle de comportement CEM associé au composant (1), dans lequel le dispositif de simulation est réalisé pour exécuter une simulation sur la base du modèle de comportement CEM déterminé selon l'une quelconque des revendications 1 à 6, dans lequel le dispositif de simulation est réalisé pour appliquer à la borne de commande virtuelle du modèle de comportement CEM une grandeur de commande spécifiée, avant la simulation du comportement du composant (1).

10. Programme informatique comprenant des instructions qui, lorsque le programme est exécuté par un ordinateur, font que celui-ci exécute toutes les étapes d'un procédé selon l'une quelconque des revendications 1 à 6.

11. Support de stockage lisible par machine sur lequel est stocké un programme informatique selon la revendication 10.

Fig. 1

Fig. 2

# Fig. 3

# Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2017091373 A1

- DE 102009002550 A1

**In der Beschreibung aufgeführte Nicht-Patentliteratur**

- Frequency domain E MI-simulation and resonance analysis of a DCDC-converter. **HILLENBRAND P. et al.** 2016 INTERNATIONAL SYMPOSIUM ON ELECTROMAGNETIC COMPATIBILITY - EMC EUROPE. IEEE, 05. September 2016, 176-181